# EUROPEAN PATENT APPLICATION

(11) **EP 4 394 855 A2**
(43) Date of publication of application: **03.07.2024**
(21) Application number: 23195787.9
(22) Date of filing: 06.09.2023
(51) Int. Cl.: H01L 21/683, H01L 23/60

(54) **METHOD AND APPARATUS FOR A SILICON DIE PREPARATION INCLUDING AUXETIC AND ELECTROSTATIC DISSIPATATIVE FEATURES**

(30) Priority: 28.12.2022 US 202218147515
(71) Applicant: Intel Corporation, Santa Clara, CA 95054 (US)
(72) Inventor: RENAVIKAR, Mukul, 97133 North Plains, OR (US); APTE, Amey Anant, 85224 Chandler, AZ (US)
(74) Representative: HGF

(57) **Abstract**

The disclosure is directed to a silicon bridge die package, a dicing-die attach film structure and a method for silicon processing including a silicon bridge die package including at least two silicon die incorporating a plurality of integrated circuits, an embedded multi-die interconnect bridge coupled to the at least two silicon die, a dicing-die attach film (DDAF) structure coupled to a silicon wafer, an electro-static discharge (ESD) preventative within the DDAF structure to prevent static charge within the DDAF structure, and an auxetic material disposed within the DDAF structure configured to prevent dicing errors. A method for preparing a silicon die for singulation includes applying an auxetic material with an ESD preventative additive to an organic resin to form a DDAF, combining the DDAF with an acrylic adhesive and a polyolefin base film, and mounting the DDAF to the silicon die.

## Description

### TECHNICAL FIELD

This disclosure generally relates to field of silicon die preparation for high density silicon die, and, in particular, dicing die-attach film improvements for high density silicon die.

### BACKGROUND

Silicon packaging architectures increasingly require high density solutions. A problem presented with high density wafer processing is a buildup of static electricity due to the use of insulating materials inherent in different adhesives. Another damage that may occur during stealth-dice-before-grind (SDBG) and cold-stretch processes, includes cracking of the die. More particularly, for proper singulation of high-aspect ratio thin die, there is a need to avoid cracking and peeling. Die cracking failures increase with the lowering of the thickness of dies and the higher density interconnections in heterogeneous silicon packages, such as EMIB. Accordingly there is a need for specialized materials to increase the efficiency and utility of EMIB and other high density silicon die architectures.

### BRIEF DESCRIPTION OF THE DRAWINGS

A detailed description is set forth below with reference to the accompanying drawings. The use of the same reference numerals may indicate similar or identical items. Various embodiments may utilize elements and/or components other than those illustrated in the drawings, and some elements and/or components may not be present in various embodiments. Elements and/or components in the figures are not necessarily drawn to scale. Throughout this disclosure, depending on the context, singular and plural terminology may be used interchangeably.
FIG. 1A illustrates a silicon die process including mounting of a dicing die attach film (DDAF) in accordance with an embodiment of the disclosure.
FIG. 1B illustrates a dicing die attach film (DDAF) structure in accordance with an embodiment of the disclosure.
FIG. 2A illustrates a silicon wafer package after a cold expansion process in accordance with an embodiment of the disclosure.
FIG. 2B illustrates a graph comparing different silicon die sizes in accordance with an embodiment of the disclosure.
FIG. 2C illustrates graphs of different failures during silicon wafer processing in accordance with an embodiment of the disclosure.
FIG. 3A illustrates auxetic material force differences in accordance with an embodiment of the disclosure.
FIG. 3B illustrates graphs showing the impact of an increasing aspect ratio on reducing stretch ability due to a positive Poisson ratio of mylar in accordance with an embodiment of the disclosure.
FIG. 4 illustrates a dicing die attach film (DDAF) structure including an auxetic material in accordance with an embodiment of the disclosure.
FIG. 5 illustrates an alternate DDAF structure including an auxetic material in accordance with an embodiment of the disclosure.
FIG. 6 illustrates a DDAF structure including a combination of auxetic materials in accordance with an embodiment of the disclosure.
FIG. 7 illustrates a chemical representation of a DDAF structure illustrating a layer of auxetic materials in accordance with an embodiment of the disclosure.
FIG. 8 illustrates a possible chemical representation of auxetic materials appropriate for a DDAF structure in accordance with an embodiment of the disclosure.
FIG. 9 illustrates a die attach film ejection and pick-and-place event in accordance with an embodiment of the disclosure.
FIG. 10 illustrates an electrostatic charge transfer from a silicon wafer in accordance with an embodiment of the disclosure.
FIG. 11 illustrates a graph of resistivity versus filler load in accordance with an embodiment of the disclosure.
FIG. 12 illustrates a nanoparticle electro-static discharge (ESD) preventative in accordance with an embodiment of the disclosure.
FIG. 13 illustrates a two dimensional nanosheet ESD preventative in accordance with an embodiment of the disclosure.
FIG. 14 illustrates a one dimensional nanotube ESD preventative in accordance with an embodiment of the disclosure.
FIG. 15 illustrates a flow diagram of a method in accordance with an embodiment of the disclosure.

### DETAILED DESCRIPTION

The following detailed description refers to the accompanying drawings. The same reference numbers may be used in different drawings to identify the same or similar elements. In the following description, for purposes of explanation and not limitation, specific details are set forth such as particular structures, architectures, interfaces, techniques, etc. in order to provide a thorough understanding of the various aspects of various embodiments. However, it will be apparent to those skilled in the art having the benefit of the present disclosure that the various aspects of the various embodiments may be practiced in other examples that depart from these specific details. In certain instances, descriptions of well-known devices, circuits, and methods are omitted so as not to obscure the description of the various embodiments with unnecessary detail. For the purposes of the present document, the phrases "A or B" and "A/B" mean (A), (B), or (A and B).

### Overview

In terms of a general overview, this disclosure is generally directed to a silicon bridge die package, a method for preparing a wafer for silicon die packaging and a dicing-die attach film (DDAF).

Silicon packaging architectures increasingly require high density solutions. One solution includes an embedded multi-die interconnect bridge (EMIB) for in-package high-density interconnection of heterogeneous silicon transistors. EMIB uses a very small bridge die with multiple routing layers that allows for increased interconnections in an embedded bridge solution. Bridge dies that connect multiple dies require a specialized die preparation, mounting using dicing die-attach film (DDAF) to avoid damage during a die pick-and place process. One damage that occurs is electrostatic discharging damage. For example, a problem presented with the high density wafer processing is a buildup of static electricity due to the use of insulating materials inherent in different adhesives. Another damage that may occur during stealth-dice-before-grind (SDBG) and cold-stretch processes, includes cracking of the die. More particularly, for proper singulation of high-aspect ratio thin die, there is a need to avoid cracking and peeling. Die cracking failures increase with the lowering of the thickness of dies and the higher density interconnections in heterogeneous silicon packages, such as EMIB. Accordingly there is a need for specialized materials to increase the efficiency and utility of EMIB and other high density silicon die architectures.

According to one or more embodiments, a silicon bridge die package, the die package includes at least two silicon die incorporating a plurality of integrated circuits, an embedded multi-die interconnect bridge coupled to the at least two silicon die, a dicing-die attach film (DDAF) structure coupled to the wafer, the DDAF structure including an epoxy die attach film, an acrylic adhesive and a polyolefin base film, an electro-static discharge (ESD) preventative within the DDAF structure to prevent static charge within the DDAF structure, and an auxetic material disposed within the DDAF structure configured to prevent dicing errors.

In one or more embodiments, the auxetic material includes an auxetic porous foam inserted within the DDAF structure.

In one or more embodiments, the auxetic porous foam is interposed between an acrylic adhesive and a polyolefin base film within the DDAF structure.

In one or more embodiments, the auxetic material includes crumpled graphene nanosheets integrated into at least one of the epoxy die attach film, the acrylic adhesive and the polyolefin base film within the DDAF structure. Further, the auxetic material may include an auxetic porous foam between the acrylic adhesive and the polyolefin base film, each of the acrylic adhesive and the polyolefin base film including crumpled graphene nanosheets.

In one or more embodiments, the ESD preventative additive includes a two dimensional nanosheets integrated with a base resin.

In one or more embodiments, the ESD preventative additive includes a one dimensional carbon nanotube integrated with the epoxy die attach film.

In one or more embodiments, the ESD preventative additive includes polyanaline one-dimensional fibers.

In one or more embodiments, the ESD preventative additive includes core shell nanoparticles including a noble metal, such as gold and silver combined with a silica.

Another embodiment is directed to a method for preparing a wafer for silicon die processing, including mixing an auxetic material and an electro-static discharge (ESD) preventative additive with an organic base resin to form a dicing-die attach film (DDAF), layering the DDAF with an acrylic adhesive and a polyolefin base film, and mounting the DDAF to the silicon die.

In one or more embodiments, the method includes inserting an auxetic porous foam within the DDAF, the auxetic porous foam interposed between the acrylic adhesive and the polyolefin base film.

In one or more embodiments, the method includes integrating crumpled graphene nanosheets into the acrylic adhesive and the polyolefin base film. In one embodiment the method further includes inserting an auxetic porous foam between the acrylic adhesive and the polyolefin base film wherein each of the acrylic adhesive and the polyolefin base film include crumpled graphene nanosheets.

Another embodiment is directed to a dicing-die attach film (DDAF) structure configured for attachment to a silicon wafer, the DDAF structure including an organic base resin including an auxetic material and an electro-static discharge (ESD) preventative additive to an organic base resin to form a dicing-die attach film (DDAF), an acrylic adhesive coupled to the DDAF, a polyolefin base film coupled to the acrylic adhesive, and a liner coupled to the DDAF.

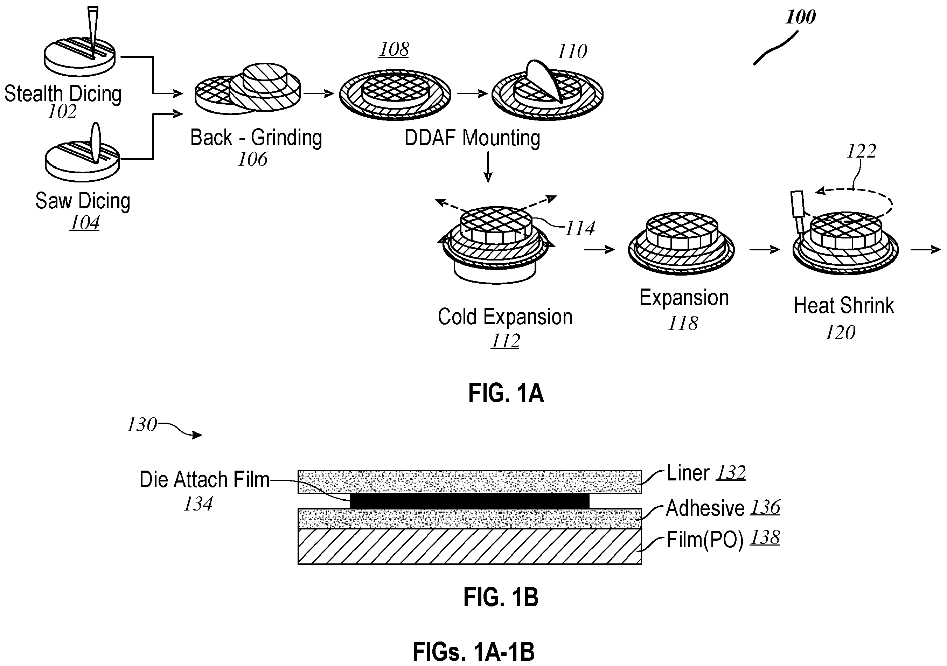

Referring now to FIG. 1A, a process flow describes a silicon wafer process in accordance with one or more embodiments. The illustrated silicon wafer process is appropriate for high density silicon wafers. As shown, the process includes stealth dicing 102 or saw dicing 104 of a silicon wafer, and backside grinding 106. Stealth dicing 102 may occur before backside grinding 106, and saw dicing 104 may occur after backside grinding 104, but only one of stealth dicing 102 and saw dicing 104 may be used in combination with backside grinding 106. For example, the wafer may be reduced via the grinding 106 from 800 microns to 50-100 microns.

Once a silicon wafer is very thin, it is mounted as shown in 108 and 110 to a film to enable singulation of the integrated circuits. As shown, a silicon wafer may be mounted on a dicing die attach film (DDAF) as shown in mounting 108 and 110 to enable separation of the wafer into different integrated circuits.

In accordance with one or more embodiments, the silicon wafer process includes applying a DDAF appropriate for combined multiple integrated circuits in a same package. Further, in one or more embodiments, the wafer supports different dimensions for the integrated circuits assembled on a package.

Referring to FIG. 1B, a DDAF structure 130 appropriate for embodiments illustrates a liner 132, an epoxy die attach film 134, an acrylic adhesive 136 and a polyolefin film 138. The DDAF structure 130 is configured to be attached to a silicon wafer to enable separation of the silicon wafer into integrated circuits via a pick-and-place type process wherein the individual "chips" are picked from the DDAF structure. Prior to the pick-and-place process, the silicon wafer die is mounted on the DDAF structure and diced into chips. As will be appreciated by one of skill in the art, after the DDAF structure is mounted on a silicon wafer, and a controlled dicing takes place that separates the epoxy die attach film and the silicon wafer into precise diced portions for the pick-and-place process, and the adhesive and polyolefin film remain intact to hold the package together during the pick-and-place process.

Referring back to FIG. 1A, once the wafer is mounted onto the DDAF, step 112 illustrates the controlled dicing as a cold expansion such that individual diced areas 114 "crack" allowing individual integrated circuits to be separated. Next, with the expansion step 118, the diced areas are expanded. Heat shrink step 120 illustrates returning the wafer to the original size to enable separation of the individual integrated circuits, referred to herein as singulation.

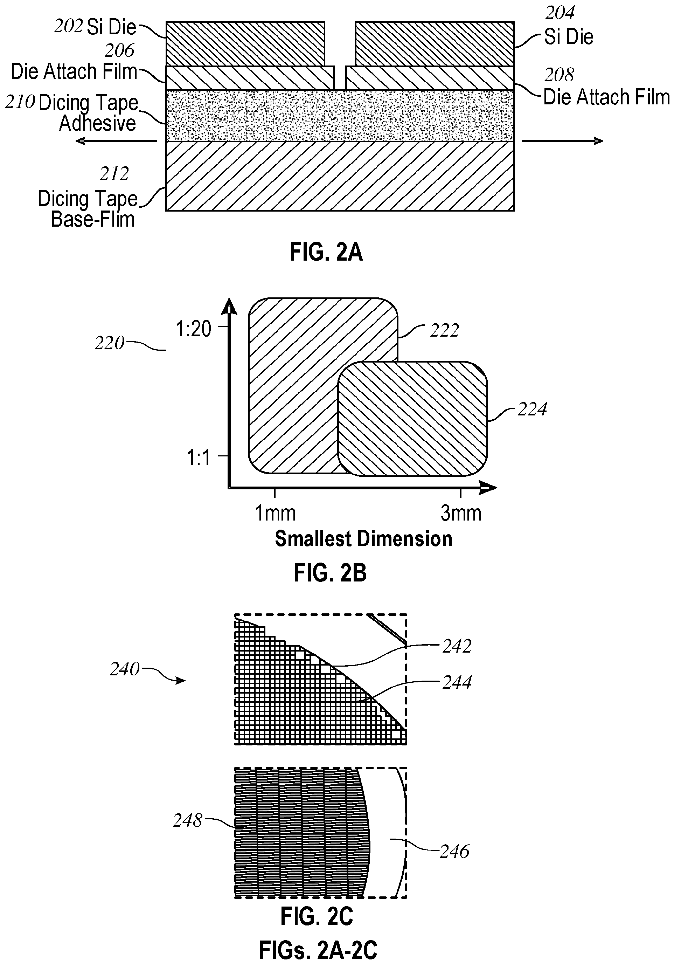

As shown, FIG. 2A illustrates a cold expansion step with silicon die 202, silicon die 204, a die attach film 206 and die attach film 208 which both attached to dicing tape adhesive 210 and dicing tape base film 212. In one or more embodiments, dicing tape adhesive 210 includes an acrylic adhesive, and dicing base film 212 includes a polyolefin base film. In accordance with one or more embodiments, FIG. 2A represents a silicon bridge die package with two silicon die, 202 and 204 that incorporate a plurality of integrated circuits. In one embodiment, the silicon bridge die package includes an embedded multi-die interconnect bridge coupled to the silicon die 202 and 204. The silicon bridge die package, includes die attach films 206 and 208 that represent a package after dicing a DDAF due to the epoxy. Thus, the DDAF structure includes epoxy die attach film, an acrylic adhesive 210 and dicing tape base film 212, which may be a polyolefin base film. In one or more embodiments, an electro-static discharge (ESD) preventative is added to one or more of the components of the DDAF including the die attach film (206, 208), the acrylic adhesive 210, and the dicing tape base film 212. Further, in one or more embodiments, an auxetic material is disposed within the DDAF structure to prevent dicing errors, such as failure of separation of tapes, flaking, and the like, as described below.

FIG. 2B illustrates a graph 220 showing a die size envelopes 222 and 224 for 100% singulation after a cold expansion to enable the separation of the integrated circuits. As shown, the smallest dimension of a singulated circuit is between 1mm to 3mm.

FIG. 2C illustrates graphs 250 that show typical failures due to poor singulation resulting in edge die flyoff242 from silicon wafer 244. Also shown is failure from unseparated die 248 where the tape 246 fails to separate. Such failures result during silicon wafer processing due to dicing failures prior to a pick-and-place procedure but after attachment of the DDAF.

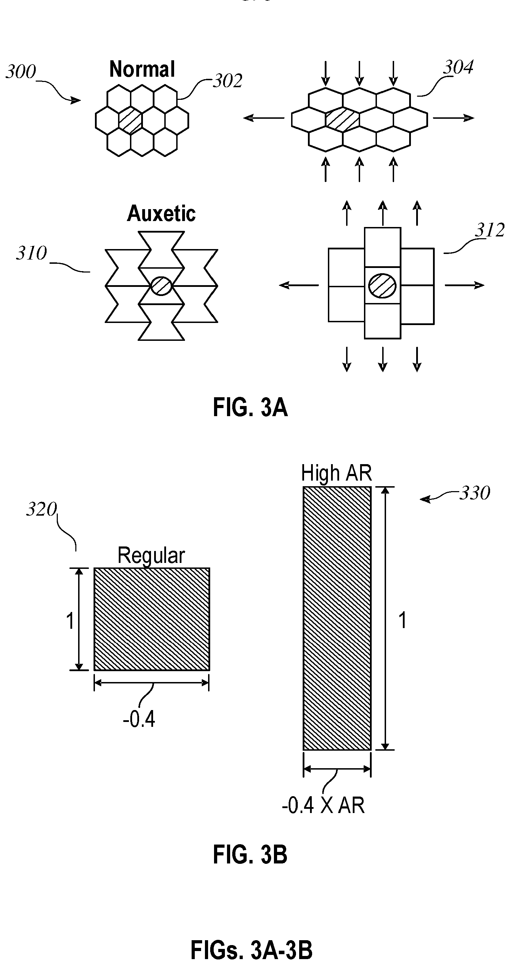

Referring now to FIGs. 3A and 3B, an embodiment is directed to introducing auxetic materials in the silicon wafer process. More particularly, in normal materials 300, lateral stretching results in longitudinal compression (e.g., when introduced to forces shown in 304; for auxetic materials, lateral stretching results in longitudinal stretching as well (e.g., when introduced to forces 312).

Similarly, FIG. 3C illustrates a hypothesized impact of increasing the aspect ratio to reduce stretching and enhance appropriate dicing during singulation. Thus, a regular material 320 is compared to a high aspect ratio material 330 with a positive Poisson ratio of ordinary mylar. One of the fundamental properties involved in mechanical stretching or deformation is the Poisson ratio. The Poisson ratio is the negative ratio of transverse strain to axial strain for isotropic and elastic material. The Poisson values lie between -1 and 0.5, with most common material having values of greater than zero. Thus, an elongation in a transverse direction is accompanied by a compression in an axial direction. However, some materials have a negative Poisson ratio wherein both the transvers and axial dimensions experience simultaneous elongation. For purposes of this disclosure "auxetic materials" refers to materials with a negative Poisson ratio. Auxetic behavior in such materials, in accordance with one or more embodiments, are leveraged to improve the singulation and die-to-die separation of high aspect ratio die, thereby reducing cracking, flyoff and failures prior to pick-and-place processes.

In accordance with one embodiment, for ordinary polyolefin-based dicing tape such as mylar base films with Poisson ratio of approximately 0.4, stretching a regular sized die along one direction is accompanied by only a 0.4X reduction of stretch in the other, which may be within a plastic limit of the material. However, for a die with high aspect ratio (such as 1:10) the same reduction in perpendicular direction may be ten times the Poisson ratio, thus leading to an increased occurrence of unseparated die as shown in FIG. 2C. According to one or more embodiments, when the stretching behavior of a DDAF structure is auxetic, the unseparated die cracking is reduced or eliminated. The stretching ability may be retained in both directions for separation.

In one or more embodiments, auxetic materials are introduced for mechanical deformation of DDAF structure 130 to improve singulation of high-aspect ratio thin die. Specifically, auxetic materials may include composites with well identifiable resin and filler structures. For example, one embodiment is directed to an auxetic matrix component. The auxetic matrix component may be introduced on polyolefin base film via a thin polyurethane porous foam with mechanical expansion within an auxetic quality with a negative Poisson ratio.

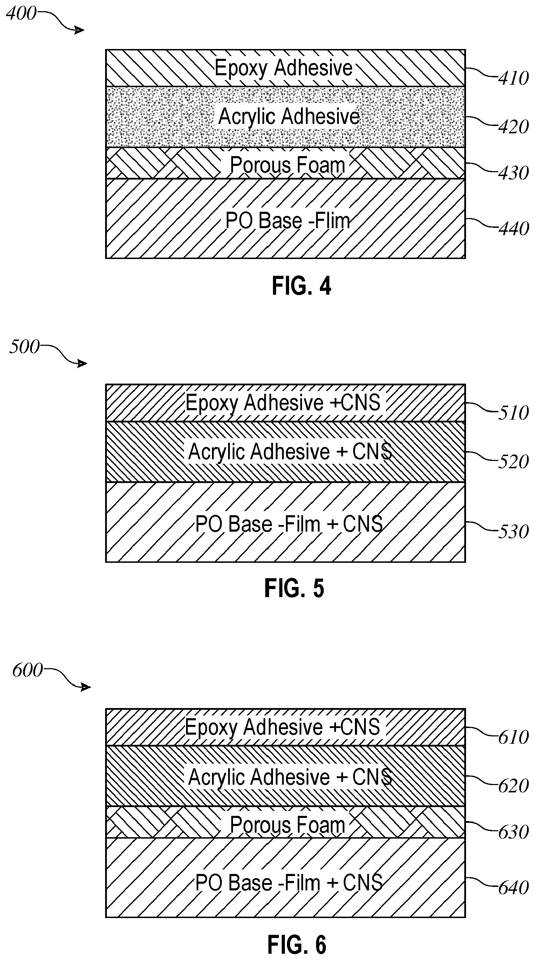

Referring to FIG. 4, an embodiment illustrates a solution for introducing auxetic materials within DDAF 400. More particularly, DDAF 400 shows an epoxy adhesive 410, an acrylic adhesive 420, a porous foam 430, which could be a thin polyurethane, and a polyolefin (PO) base film 440. Porous foam 430, in one embodiment, is an auxetic foam including a regular filler combined with an auxetic matrix. One auxetic matrix includes graphene, which is an allotrope of carbon with a single layer of atoms arranged in a two-dimensional honeycomb lattice nanostructure. Another auxetic material may include a graphene nanoparticles or molybdenum disulfide nanoparticles or some combination of the two. In one or more embodiments, the nanoparticles are nanotubes and/or nanosheets.

Referring to FIG. 5, another embodiment illustrates a solution for introducing auxetic materials into a filler component. As shown, DDAF 500 includes an epoxy adhesive with a crumpled nanosheet 510, an acrylic a heat adhesive with a crumpled nanosheet 520 and a polyolefin film base with a crumpled nanosheet 530. As referred to herein, a crumpled nanosheet may include deposited layers of graphene oxide onto a shrink film, which is then shrunken such that the film is dissolved before being shrunken again on another sheet of film to form "wrinkles" or a crumpled nanosheet.

To incorporate auxetic behavior in the filler components these ultra-thin crumpled nanosheets may be of graphene or molybdenum disulfide. In one embodiment, these crumpled nanosheets are incorporated via a suitable surface functionalization. In one embodiment, the auxetic behavior of graphene crumpled nanosheets maybe via vacancy defect-induced crumpling. In one or more embodiments, graphene maybe chemically induced to make it more compatible with any organic resin matrix of an adhesive. As will be appreciated by those of skill in the art, graphene is organic, therefore surface functionalization makes the graphene more compatible with organic resins, such as may be used in die attach film epoxies and the like.

Referring now to FIG. 6, one embodiment is directed to combining solutions shown in FIGs. 4 and 5. FIG. 6 shows DDAF 600 with epoxy adhesive combined with crumpled nanosheets 610, acrylic adhesive with crumpled nanosheets 620, porous foam 630, and polyolefin based film with crumpled nanosheets 640. The combination of auxetic materials may beneficially reduce die failure prior to pick-and-place processes. However, one of skill in the art with the benefit of the disclosure will appreciate that the addition of auxetic materials in any part of DDAF 600 will benefit silicon processing and prevent cracking and is within the scope of embodiments. Thus, adding an auxetic material

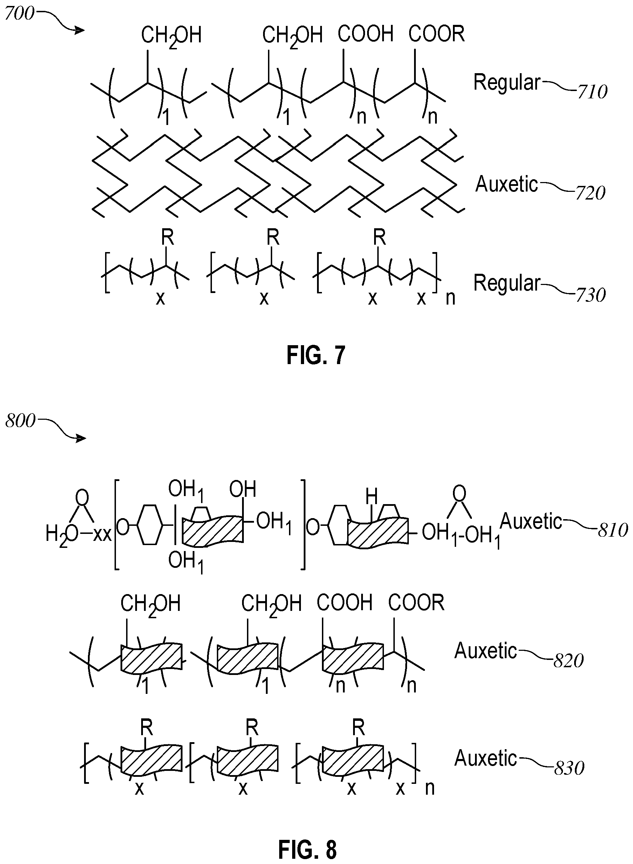

Referring now to FIG. 7, the chemical schematic incorporating auxetic structures within an existing material design is illustrated in DDAF 700 showing regular chemical structure 710 auxetic chemical structure 720 and regular chemical structure 730. FIG. 7 illustrates a porous foam solution wherein the auxetic material is inserted in a DDAF structure.

Referring now to FIG. 8, another chemical structure of a DDAF 800 is shown illustrating auxetic layer 810, auxetic layer 820, and auxetic layer 830. Thus, FIG. 8 illustrates incorporating auxetic materials into each layer of a DDAF. In one or more embodiments, introducing auxetic materials results in a DDAF structure that prevents cracking, falloff and failure to separate from dicing tapes and the like.

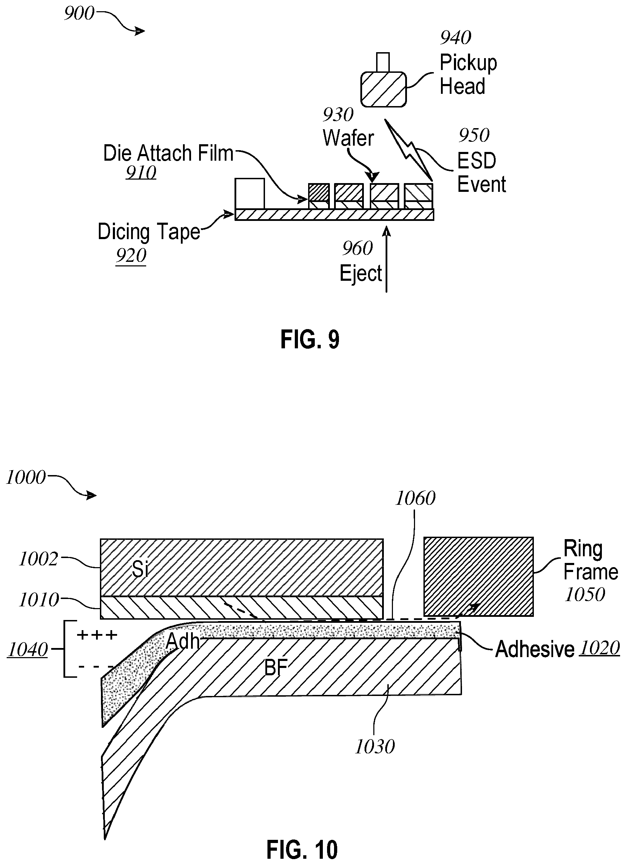

Referring now to FIG. 9, one embodiment is directed to further altering DDAF 130 shown in FIG. 1B, to prevent catastrophic electrostatic discharge. As shown, structure 900 includes a die attach film 910 such as DDAF 130 structure coupled to dicing tape 920. Die attach film 910 is coupled to wafers 930 which must be separated through dicing and detached with pickup head 940. In one embodiment, pickup head 940 picks up a wafer and bonds the element picked up to cavities in a substrate. Eject 960 illustrates a force below dicing tape 920 identifying when a pick-and-place process may take place.

An electrostatic discharge (ESD) event 950, illustrated by a lightning figure, may occur which damages the wafer 930 during the die pick-and-place process. More specifically, static charge may accumulate on a wafer or on a tape, such as a DDAF or the like. If so, when the pick-and-place places an integrated circuit and the circuit makes contact after being placed, a charge will quickly dissipate and could destroy the circuit.

In one or more embodiments, the ESD event 950 may be dissipated such that an accumulated static charge does not cause damage to sensitive components such as wafer 930 and integrated circuits on a silicon die. ESD events that are not controlled result in yield loss due to electrical shorting of the silicon die due to rapid dissipation of any charge buildup. Such rapid dissipation may occur during pick-and-place of the different components following singulation.

As will be appreciated by those of skill in the art, silicon processing die attach films are typically insulating type films, meaning that the resistivity of the film is above 10¹² ohms per square. Typical die attach films thus are anti-static films with a resistivity between 10¹⁰ and 10¹² ohms per square.

According to one or more embodiments, alterations to the die attach film enable a package with a resistivity between 10³ and 10⁹ ohms per square. Thus, because a static dissipative film has a resistivity between 10⁶ and 10⁹ ohms per square, and a conductive film has a resistivity between 10³ and 10⁵ ohms per square, embodiments include die attach films that are either static dissipative or conductive, as may be appropriate for a given material.

Referring to FIG. 10, according to one or more embodiments, a process 1000 is illustrated showing silicon wafer 1002, DDAF 1010, adhesive 1020 attached to base film 1030. FIG. 10 illustrates that a typical wafer-level dicing tape and die attach film process that may generate a charge when a liner, such as a DDAF is peeled off before mounting a thinned wafer on a DAF because a wafer and a DAF layer may be singulated together on top of an underlying dicing tape, which is followed up by a pick-and-place of the die and DAF. The DAF layer and adhesive layer 1020 may be both organic and insulating such that separation of such layers may induce a charge build up. In one or more embodiments, a charge may be dissipated through the DDAF 1010 and on to ring frame 1050 which may be steel, if the DDAF 1010 and the dicing tape adhesive 1020 are not insulating.

As shown, according to an embodiment, additives to DDAF 1010 enable charge 1040 to dissipate along a dissipation path 1060 to ring frame 1050 prior to a pick-and-place. The dissipation of charge therefore prevents any static buildup of charge that could destroy silicon 1002.

To implement the dissipation path 1060, a material modification allows an overall resistivity of DDAF 1010 layer in a dissipative resistivity of 10⁹ to 10¹² ohm per square. so that the built up static charge neither accumulates nor rapidly discharges away. Common techniques of making insulative materials conductive may include adding small conductive particles such as carbon or silver flakes, however, because of percolation effect, there is no change in behavior until a certain threshold fraction of an added filler followed by a sudden change over a very short range.

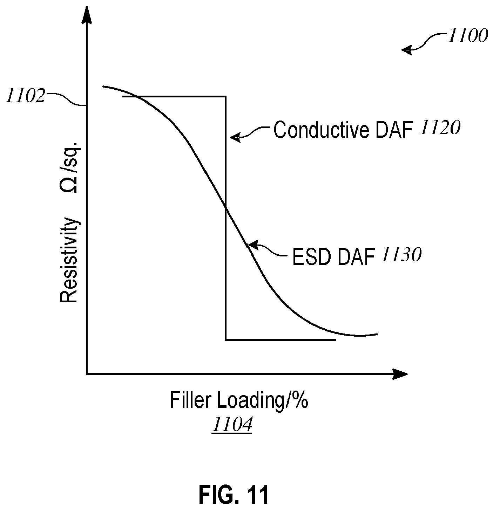

Referring to FIG. 11, a graph 1100 shows resistivity 1102 versus filler loading percentage 1104 for die attach films such as conductive die attach film 1120 and electrostatic discharge die attach film 1130. FIG. 11 illustrates that the behavior caused by threshold fractions cause a sudden change. Thus, achieving stable resistivity is difficult. For this reason, conducting particles or fillers are added to an insulating matrix. One type of conducting particle includes inherently conducting polymers, as described below.

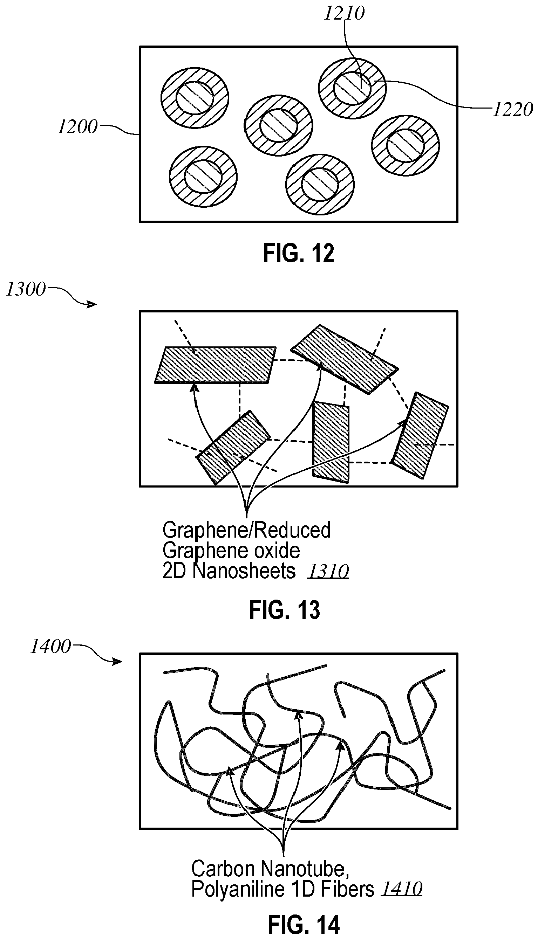

In one or more embodiments, hybrid fillers, including polymers, provide "core-shell" structures in which a core and a shell combine as nanoparticles that include both a dielectric and a conductor. More particularly, referring to FIG. 12, a hybrid filler embodiment includes a metal and a dielectric such as silica as a hybrid filler as a core and a shell. A metal may include noble metal such as gold or silver that is conductive. Combined with the conductive material is a dielectric. The core-shell morphology allows a tunable thickness of the core and shell materials as compared to metallic fillers that achieve rapid conductivity above a percolation threshold as shown in FIG. 11. Core-shell fillers may be combined with metallic fillers for added resistivity that may be further enable a tunable relative ratio. Thus, in one embodiment, adhesive 1020 shown in FIG. 10 may have improved dissipative ability due to having a composite adhesive filler.

FIG. 12 illustrates a metal-silica core shell 1200, wherein the core 1210 has a different resistivity from shell 1220. In one embodiment, core 1210 is either gold or silver, and shell 1220 is silica. Another embodiment is directed to the reverse, with a core of silica and a shell of either gold or silver. Thus, core 1210 or shell 1220 may have conductive material that is tunable according to a desired dissipative ability.

FIG. 13 illustrates another embodiment that provides another ESD resistivity filler for a DDAF to avoid a static charge, filler 1300 includes a graphene/reduced graphene oxide two dimensional nanosheets 1310.

FIG. 14 illustrates another embodiment that provides another ESD resistivity filler for a DDAF to avoid a state charge, filler 1400 may include carbon nanotubes and/or polyaniline as one dimensional fibers 1410. Thus, one-dimensional nanotubes are capable of providing a resistivity for avoiding electrostatic charge.

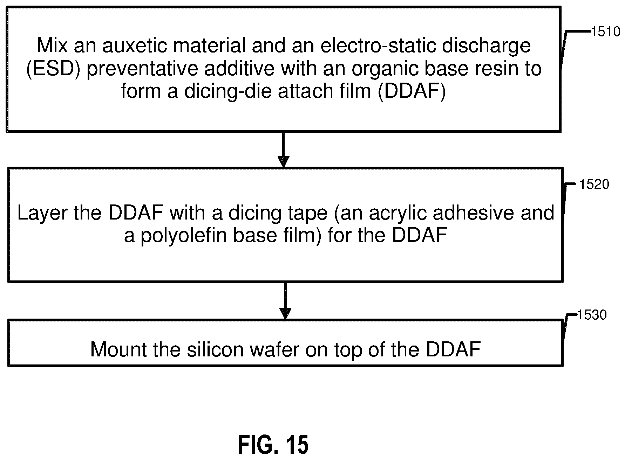

Referring now to FIG. 15, a flow diagram illustrates a method for silicon wafer processing in accordance with one or more embodiments.

Block 1510 provides for mixing an auxetic material and an electro-static discharge (ESD) preventative additive with an organic base resin to form a dicing-die attach film (DDAF). For example, FIGs. 4, 5, and 6 illustrate different auxetic solutions with a DDAF and FIGs. 12, 13, and 14 illustrate different ESD preventative additives that may be added to a DDAF. For example, FIG. 2A represents a silicon die package with an embedded multi-die interconnect bridge coupled to the at least two silicon die with both auxetic material and ESD preventative additive. Block 1510 may include inserting an auxetic porous foam within the DDAF. For example, FIGs. 4 and 6 illustrate auxetic porous foam 430 and 630 respectively. Block 1510 also may include integrating crumpled graphene nanosheets into the acrylic adhesive and the polyolefin base film. For example, FIGs. 4 and 5 illustrate crumpled nanosheets (CNS) incorporated into each layer of DDAF structures 400 and 500.

In one or more embodiments, the ESD preventative additive includes a two dimensional carbon nanosheet integrated with the organic resin. In another embodiment, the ESD preventative additive includes a one dimensional carbon nanotube integrated with the organic resin. In another embodiment, the ESD preventative additive includes polyanaline one-dimensional fibers. In another embodiment, the ESD preventative additive includes core shell nanoparticles including a noble metal combined with a silica.

Block 1520 provides for layering the DDAF with a dicing tape (e.g., an acrylic adhesive and a polyolefin base film) for the DDAF. For example, as shown in FIG. 1B, 4, 5, and 6 different layering includes acrylic adhesive and polyolefin base film.

Block 1530 provides for mounting the silicon wafer on top of the DDAF. For example, FIG. 1A illustrates DDAF mounting in steps 108 and 110.

In the above disclosure, reference has been made to the accompanying drawings, which form a part hereof, which illustrate specific implementations in which the present disclosure may be practiced. It is understood that other implementations may be utilized, and structural changes may be made without departing from the scope of the present disclosure. References in the specification to "one embodiment," "an embodiment," "an example embodiment," "an example embodiment," "example implementation," etc., indicate that the embodiment or implementation described may include a particular feature, structure, or characteristic, but every embodiment or implementation may not necessarily include the particular feature, structure, or characteristic. Moreover, such phrases are not necessarily referring to the same embodiment or implementation. Further, when a particular feature, structure, or characteristic is described in connection with an embodiment or implementation, one skilled in the art will recognize such feature, structure, or characteristic in connection with other embodiments or implementations whether or not explicitly described. For example, various features, aspects, and actions described above with respect to an autonomous parking maneuver are applicable to various other autonomous maneuvers and must be interpreted accordingly.

Implementations of the systems, apparatuses, devices, and methods disclosed herein may comprise or utilize one or more devices that include hardware, such as, for example, one or more processors and system memory, as discussed herein. An implementation of the devices, systems, and methods disclosed herein may communicate over a computer network.

Computer-executable instructions comprise, for example, instructions and data which, when executed at a processor, cause the processor to perform a certain function or group of functions. The computer-executable instructions may be, for example, binaries, intermediate format instructions such as assembly language, or even source code. Although the subject matter has been described in language specific to structural features and/or methodological acts, it is to be understood that the subject matter defined in the appended claims is not necessarily limited to the described features or acts described above. Rather, the described features and acts are disclosed as example forms of implementing the claims.

A memory device can include any one memory element or a combination of volatile memory elements (e.g., random access memory (RAM, such as DRAM, SRAM, SDRAM, etc.)) and non-volatile memory elements (e.g., ROM, hard drive, tape, CDROM, etc.). Moreover, the memory device may incorporate electronic, magnetic, optical, and/or other types of storage media. In the context of this document, a "non-transitory computer-readable medium" can be, for example but not limited to, an electronic, magnetic, optical, electromagnetic, infrared, or semiconductor system, apparatus, or device. More specific examples (a non-exhaustive list) of the computer-readable medium would include the following: a portable computer diskette (magnetic), a random-access memory (RAM) (electronic), a read-only memory (ROM) (electronic), an erasable programmable read-only memory (EPROM, EEPROM, or Flash memory) (electronic), and a portable compact disc read-only memory (CD ROM) (optical). Note that the computer-readable medium could even be paper or another suitable medium upon which the program is printed, since the program can be electronically captured, for instance, via optical scanning of the paper or other medium, then compiled, interpreted or otherwise processed in a suitable manner if necessary, and then stored in a computer memory.

While various embodiments of the present disclosure have been described above, it should be understood that they have been presented by way of example only, and not limitation. It will be apparent to persons skilled in the relevant art that various changes in form and detail can be made therein without departing from the spirit and scope of the present disclosure. Thus, the breadth and scope of the present disclosure should not be limited by any of the above-described example embodiments but should be defined only in accordance with the following claims and their equivalents. The foregoing description has been presented for the purposes of illustration and description. It is not intended to be exhaustive or to limit the present disclosure to the precise form disclosed. Many modifications and variations are possible in light of the above teaching. Further, it should be noted that any or all of the aforementioned alternate implementations may be used in any combination desired to form additional hybrid implementations of the present disclosure. For example, any of the functionality described with respect to a particular device or component may be performed by another device or component. Further, while specific device characteristics have been described, embodiments of the disclosure may relate to numerous other device characteristics. Further, although embodiments have been described in language specific to structural features and/or methodological acts, it is to be understood that the disclosure is not necessarily limited to the specific features or acts described. Rather, the specific features and acts are disclosed as illustrative forms of implementing the embodiments. Conditional language, such as, among others, "can," "could," "might," or "may," unless specifically stated otherwise, or otherwise understood within the context as used, is generally intended to convey that certain embodiments could include, while other embodiments may not include, certain features, elements, and/or steps. Thus, such conditional language is not generally intended to imply that features, elements, and/or steps are in any way required for one or more embodiments.

### Terminology

For the purposes of the present document, the following terms and definitions are applicable to the examples and embodiments discussed herein.

The term "circuitry" as used herein refers to, is part of, or includes hardware components such as an electronic circuit, a logic circuit, a processor (shared, dedicated, or group) and/or memory (shared, dedicated, or group), an Application Specific Integrated Circuit (ASIC), a field-programmable device (FPD) (e.g., a field-programmable gate array (FPGA), a programmable logic device (PLD), a complex PLD (CPLD), a high-capacity PLD (HCPLD), a structured ASIC, or a programmable SoC), digital signal processors (DSPs), etc., that are configured to provide the described functionality. In some embodiments, the circuitry may execute one or more software or firmware programs to provide at least some of the described functionality. The term "circuitry" may also refer to a combination of one or more hardware elements (or a combination of circuits used in an electrical or electronic system) with the program code used to carry out the functionality of that program code. In these embodiments, the combination of hardware elements and program code may be referred to as a particular type of circuitry.

The term "interface circuitry" as used herein refers to, is part of, or includes circuitry that enables the exchange of information between two or more components or devices. The term "interface circuitry" may refer to one or more hardware interfaces, for example, buses, I/O interfaces, peripheral component interfaces, network interface cards, and/or the like.

The term "computer system" as used herein refers to any type interconnected electronic devices, computer devices, or components thereof. Additionally, the term "computer system" and/or "system" may refer to various components of a computer that are communicatively coupled with one another. Furthermore, the term "computer system" and/or "system" may refer to multiple computer devices and/or multiple computing systems that are communicatively coupled with one another and configured to share computing and/or networking resources.

The terms "coupled," "communicatively coupled," along with derivatives thereof are used herein. The term "coupled" may mean two or more elements are in direct physical or electrical contact with one another, may mean that two or more elements indirectly contact each other but still cooperate or interact with each other, and/or may mean that one or more other elements are coupled or connected between the elements that are said to be coupled with each other. The term "directly coupled" may mean that two or more elements are in direct contact with one another. The term "communicatively coupled" may mean that two or more elements may be in contact with one another by a means of communication including through a wire or other interconnect connection, through a wireless communication channel or link, and/or the like.

Various example embodiments are provided below.

Example 1 may include a silicon bridge die package, the silicon bridge die package comprising: at least two silicon die incorporating a plurality of integrated circuits; an embedded multi-die interconnect bridge coupled to the at least two silicon die; a dicing-die attach film (DDAF) structure coupled to a wafer, the DDAF structure including an epoxy die attach film, an acrylic adhesive and a polyolefin base film; an electro-static discharge (ESD) preventative additive within the DDAF structure to prevent static charge within the DDAF structure; and an auxetic material disposed within the DDAF structure and configured to prevent dicing errors.

Example 2 may include the silicon bridge die package of example 1 and/or any other example herein, wherein the wafer is associated with stealth dicing or saw dicing before grinding (SDBG).

Example 3 may include the silicon bridge die package of example 1 and/or any other example herein, wherein the auxetic material comprises: an auxetic porous foam inserted within the DDAF structure.

Example 4 may include the silicon bridge die package of example 3 and/or any other example herein, wherein the auxetic porous foam is interposed between an acrylic adhesive and a polyolefin base film within the DDAF structure.

Example 5 may include the silicon bridge die package of example 1 and/or any other example herein, wherein the auxetic material includes crumpled graphene nanosheets integrated into at least one of the epoxy die attach film, the acrylic adhesive and the polyolefin base film within the DDAF structure.

Example 6 may include the silicon bridge die package of example 5 and/or any other example herein, wherein the auxetic material further includes an auxetic porous foam between the acrylic adhesive and the polyolefin base film, each of the acrylic adhesive and the polyolefin base film including crumpled graphene nanosheets.

Example 7 may include the silicon bridge die package of example 1 and/or any other example herein, wherein the ESD preventative additive includes a two dimensional nanosheet integrated with the epoxy die attach film.

Example 8 may include the silicon bridge die package of example 1 and/or any other example herein, wherein the ESD preventative additive includes a one dimensional carbon nanotube integrated with the epoxy die attach film.

Example 9 may include the silicon bridge die package of example 1 and/or any other example herein, wherein the ESD preventative additive includes polyanaline one-dimensional fibers.

Example 10 may include the silicon bridge die package of example 1 and/or any other example herein, wherein the ESD preventative additive includes core shell nanoparticles including a noble metal combined with a silica.

Example 11 may include the silicon bridge die package of example 10 and/or any other example herein, wherein the noble metal is gold or silver.

Example 12 may include a method for preparing a wafer for silicon die processing, the method comprising: mixing an auxetic material and an electro-static discharge (ESD) preventative additive with an organic resin to form a dicing-die attach film (DDAF); layering the DDAF with an acrylic adhesive and a polyolefin base film; and mounting the DDAF to the silicon die.

Example 13 may include the method of example 12 and/or any other example herein further comprising: inserting an auxetic porous foam within the DDAF, the auxetic porous foam interposed between the acrylic adhesive and the polyolefin base film.

Example 14 may include the method of example 12 and/or any other example herein further comprising: integrating crumpled graphene nanosheets into the acrylic adhesive and the polyolefin base film.

Example 15 may include the method of example 14 and/or any other example herein further comprising: inserting an auxetic porous foam between the acrylic adhesive and the polyolefin base film wherein each of the acrylic adhesive and the polyolefin base film include crumpled graphene nanosheets.

Example 16 may include the method of example 12 and/or any other example herein wherein the ESD preventative additive includes a two dimensional carbon nanosheet integrated with the organic resin, a one dimensional carbon nanotube integrated with the organic resin, or polyanaline one-dimensional fibers.

Example 17 may include the method of example 12 and/or any other example herein wherein the ESD preventative additive includes core shell nanoparticles including a noble metal combined with a silica.

Example 18 may include a dicing-die attach film (DDAF) structure configured for attachment to a silicon wafer, the DDAF structure comprising: an organic base resin including an auxetic material and an electro-static discharge (ESD) preventative additive to an organic base resin to form a dicing-die attach film (DDAF); an acrylic adhesive coupled to the DDAF; a porous foam including auxetic materials coupled to the acrylic adhesive; and a polyolefin base film coupled to the porous foam.

Example 19 may include the dicing-die attach film (DDAF) structure of example 18 and/or any other example herein, wherein each of the acrylic adhesive and the polyolefin base film include crumpled graphene nanosheets.

Example 20 may include the dicing-die attach film (DDAF) structure of example 18 and/or any other example herein, wherein the ESD preventative additive includes core shell nanoparticles including a noble metal combined with a silica.

## Claims

1. A silicon bridge die package, the silicon bridge die package comprising:
at least two silicon die incorporating a plurality of integrated circuits;
an embedded multi-die interconnect bridge coupled to the at least two silicon die;
a dicing-die attach film (DDAF) structure coupled to a wafer, the DDAF structure including an epoxy die attach film, an acrylic adhesive and a polyolefin base film;
an electro-static discharge (ESD) preventative additive within the DDAF structure to prevent static charge within the DDAF structure; and
an auxetic material disposed within the DDAF structure and configured to prevent dicing errors.

2. The silicon bridge die package of claim 1, wherein the wafer is associated with stealth dicing or saw dicing before grinding (SDBG).

3. The silicon bridge die package of claim 1, wherein the auxetic material comprises:
an auxetic porous foam inserted within the DDAF structure.

4. The silicon bridge die package of claim 3, wherein the auxetic porous foam is interposed between an acrylic adhesive and a polyolefin base film within the DDAF structure.

5. The silicon bridge die package of claim 1, wherein the auxetic material includes crumpled graphene nanosheets integrated into at least one of the epoxy die attach film, the acrylic adhesive and the polyolefin base film within the DDAF structure.

6. The silicon bridge die package of claim 5, wherein the auxetic material further includes an auxetic porous foam between the acrylic adhesive and the polyolefin base film, each of the acrylic adhesive and the polyolefin base film including crumpled graphene nanosheets.

7. The silicon bridge die package of claim 1, wherein the ESD preventative additive includes a two dimensional nanosheet integrated with the epoxy die attach film.

8. The silicon bridge die package of claim 1, wherein the ESD preventative additive includes a one dimensional carbon nanotube integrated with the epoxy die attach film.

9. The silicon bridge die package of any one of claims 1-8, wherein the ESD preventative additive includes polyanaline one-dimensional fibers.

10. A method for preparing a wafer for silicon die processing, the method comprising:
mixing an auxetic material and an electro-static discharge (ESD) preventative additive with an organic resin to form a dicing-die attach film (DDAF);
layering the DDAF with an acrylic adhesive and a polyolefin base film; and mounting the DDAF to the silicon die.

11. The method of claim 10, further comprising:
inserting an auxetic porous foam within the DDAF, the auxetic porous foam interposed between the acrylic adhesive and the polyolefin base film.

12. The method of claim 10, further comprising:
integrating crumpled graphene nanosheets into the acrylic adhesive and the polyolefin base film.

13. The method of any one of claims 10-12, further comprising:
inserting an auxetic porous foam between the acrylic adhesive and the polyolefin base film wherein each of the acrylic adhesive and the polyolefin base film include crumpled graphene nanosheets.

14. A dicing-die attach film (DDAF) structure configured for attachment to a silicon wafer, the DDAF structure comprising:
an organic base resin including an auxetic material and an electro-static discharge (ESD) preventative additive to an organic base resin to form a dicing-die attach film (DDAF);
an acrylic adhesive coupled to the DDAF;
a porous foam including auxetic materials coupled to the acrylic adhesive; and a polyolefin base film coupled to the porous foam.

15. The dicing-die attach film (DDAF) structure of claim 18, wherein each of the acrylic adhesive and the polyolefin base film include crumpled graphene nanosheets.
